# EUROPÄISCHE PATENTSCHRIFT

(11) **EP 1 413 776 B1**
(45) Veröffentlichungstag und Bekanntmachung des Hinweises auf die Patenterteilung: **22.06.2005**
(21) Anmeldenummer: 04000604.1
(22) Anmeldetag: 17.11.1999
(51) Int. Cl.: F15C 5/00, B01L 11/00

(54) **Anschlussträger für plattenförmige Mikrokomponenten**
Interconnection support for plate-like microcomponents
Support de connexion pour microcomposants sous forme de plaques

(30) Priorität: 24.11.1998 DE 19854096
(43) Veröffentlichungstag der Anmeldung: 28.04.2004
(62) Teilanmeldung aus: 99956004.8
(73) Patentinhaber: MERCK PATENT GmbH, 64293 Darmstadt (DE)
(72) Erfinder: Dr. Hohmann, Michael, 63179 Obertshausen (DE); Schmelz, Michael, 64560 Riedstadt (DE); Wurziger, Hanns, 64291 Darmstadt (DE); Schwesinger, Norbert, 85386 Eching (DE)
(74) Vertreter: Habermann, Jan

(56) Entgegenhaltungen:
- EP-A- 0 040 186
- DE-A- 19 746 585
- US-A- 5 519 635

## Beschreibung

Die Erfindung betrifft ein Anschlusssystem für plattenförmige Mikrokomponenten.

Plattenförmige Mikrokomponenten, wie Mikromischer, Mikropumpen, Mikroventile oder dergleichen, dienen zur Durchführung von chemischen Reaktionen mit geringsten Massenströmen. Der Einsatz von Mikrokomponenten ermöglicht eine exakte Temperaturkontrolle und gute Durchmischung, so dass eine wesentlich genauere Prozesskontrolle bei erhöhter Sicherheit ermöglicht wird.

Üblicherweise bestehen die Mikrokomponenten aus mehreren aufeinander liegenden planparallelen Platten, die in ihren aufeinander liegenden Oberflächen die für die erforderliche Funktion benötigten Strukturen enthalten. Wegen der guten thermischen Leitfähigkeit und der Strukturierbarkeit bestehen diese Platten üblicherweise aus Silizium (sog. Siliziumwafer), die im Inneren eine der Funktion der Mikrokomponente angepassten Geometrie enthalten. Daneben ist aber auch der Einsatz anderer, chemisch beständiger und den Einsatzbedingungen angepasster Werkstoffe möglich.

Bisher wurden in erster Linie einzelne Mikrokomponenten, üblicherweise in plattenförmiger Ausführung, eingesetzt und jeweils einzeln mit den Zufuhr- und Abfuhrleitungen für flüssige und gasförmige Stoffkomponenten sowie - soweit erforderlich - mit elektrischen Anschlüssen versehen. Ein wesentlicher Aspekt des Einsatzes solcher Mikrokomponenten ist jedoch der Anschluss an laborübliche Geräte, damit die Vorteile der Mikrosysteme in labortechnischen Maßstäben eingesetzt werden können.

Aufgabe der Erfindung ist es daher, eine Schnittstelle zwischen Mikrotechnik und Labortechnik zu schaffen, über die die Mikrosysteme in sicherer und einfacher Weise an laborübliche Geräte adaptiert werden können.

Diese Aufgabe wird erfindungsgemäß gelöst durch ein Anschlusssystem für plattenförmige Mikrokomponenten zur Durchführung von chemischen Reaktionen mit mehreren gemeinsam befestigbaren Trägerschienen (2), die auf einer Trägerplatte (3) befestigbar sind, wobei die Trägerschienen (2) einen Einsteckschlitz zur Aufnahme eines Einsteckrandes einer plattenförmigen Mikrokomponente aufweisen, wobei in mindestens einer der beiden Seitenwände des Einsteckschlitzes jeder Trägerschiene Leitungsanschlüsse zur Leitung flüssiger und gasförmiger Stoffkomponenten vorgesehen sind, die mit zugeordneten Anschlüssen in mindestens einer Außenseite der plattenförmigen Mikrokomponente verbindbar sind.

Mit diesem Anschlusssystem wird durch die miteinander verbundenen Trägerschienen gleichzeitig auch eine mechanisch stabile Halterung geschaffen. Das Anschlusssystem ermöglicht die Versorgung mit Reagenzien und die Realisierung eines elektrischen Anschlusses, beispielsweise für die Messtechnik, Heizung, Kühlung usw. Die Mikrokomponenten können in einfacher Weise angeschlossen und leicht ausgewechselt werden.

Vorzugsweise ist vorgesehen, dass mehrere Trägerschienen miteinander zu einer Trägerplatte verbunden sind. Mit einer solchen universellen Anschlusstechnik wird auf engstem Raum ein mechanisch stabiler Aufbau von Mikrosystemen mit standardisierter Versorgungstechnik möglich.

Einer vorteilhaften Ausgestaltung des Erfindungsgedankens zufolge ist vorgesehen, dass mehrere Trägerschienen auf einer Trägerplatte befestigt sind. Durch die Verwendung mehrerer Trägerschienen auf einer gemeinsamen Trägerplatte lässt sich eine räumlich kompakte Unterbringung mehrerer plattenförmiger Mikrokomponenten erreichen. Die gemeinsame Trägerplatte führt zu zusätzlicher mechanischer Stabilität und vereinfacht die Verbindung der Trägerschienen miteinander, bzw. mit der gemeinsamen Trägerplatte.

Gemäß einer bevorzugten Ausführungsform der Erfindung ist vorgesehen, dass mindestens eine der Seitenwände des Einsteckschlitzes mindestens eine Gewindebohrung zur Aufnahme einer Anschlussverschraubung aufweist, die gegen die zugeordnete Außenseite der plattenförmigen Mikrokomponente schraubbar ist. Damit wird gleichzeitig ein dichter Anschluss der Mikrokomponente an die Anschlussverschraubung und zugleich eine sichere Festlegung der plattenförmigen Mikrokomponente in der Trägerschiene erreicht.

Um eine exakte und zuverlässige Ausrichtung der plattenförmigen Mikrokomponente in der Trägerschiene zu gewährleisten, ist in weiterer Ausgestaltung des Erfindungsgedankens vorgesehen, dass an einem Ende des Einsteckschlitzes eine in Schlitzlängsrichtung wirkende Feder angeordnet ist, durch die die plattenförmige Mikrokomponente gegen einen Zentrieranschlag am anderen Ende des Einsteckschlitzes drückbar ist.

Zwischen den Gewindebohrungen oder in der gegenüberliegenden Seitenwand des Einsteckschlitzes können elektrische Kontaktflächen angeordnet sein, die mit zugeordneten elektrischen Kontakten der plattenförmigen Mikrokomponente in Berührung bringbar sind. Damit wird zugleich ein elektrischer Anschluss hergestellt, wie er in vielen Fällen für Messfühler in der Mikrokomponente, für Heizung, Kühlung oder ähnliche Zwecke erforderlich ist.

In weiterer Ausbildung des Erfindungsgedankens kann vorgesehen werden, dass die Trägerschiene mit einer sich senkrecht zur Trägerplatte erstreckenden Anschlussschiene verbunden ist, die einen Einsteckschlitz zur Aufnahme eines weiteren Einsteckrandes der plattenförmigen Mikrokomponente aufweist, wobei in mindestens einer der beiden Seitenwände des Einsteckschlitzes der Anschlussschiene Leitungsanschlüsse vorgesehen sind, die mit zugeordneten Anschlüssen in mindestens einer Außenseite der plattenförmigen Mikrokomponente verbindbar sind.

Die von der Trägerschiene senkrecht hochstehende Anschlussschiene bietet einerseits die Möglichkeit, dort weitere Leitungsanschlüsse vorzusehen; andererseits bildet diese Anschlussschiene eine stabile Halterung für die eingesteckte plattenförmige Mikrokomponente, so dass auf sonstige Halterungen und Festlegungen verzichtet werden kann.

Weitere vorteilhafte Ausgestaltungen des Erfindungsgedankens sind Gegenstand weiterer Unteransprüche.

Nachfolgend werden Ausführungsbeispiele der Erfindung näher erläutert, die in der Zeichnung dargestellt sind. Es zeigt, jeweils in räumlicher Darstellungsweise:
Fig. 1 ein Anschlusssystem für plattenförmige Mikrokomponenten mit einer auf einer Trägerplatte befestigten Trägerschiene,
Fig. 2 ein Anschlusssystem mit zusätzlicher Anschlussschiene und
Fig. 3 ein Anschlusssystem mit einem von der Trägerschiene getrennten Anschlusshalter.

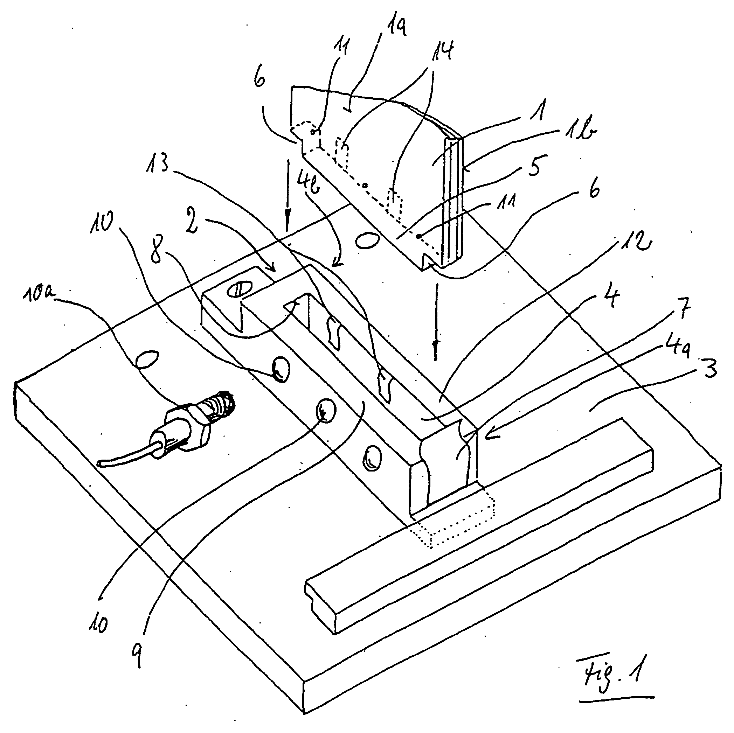

Das in Fig. 1 dargestellte Anschlusssystem dient zur Aufnahme mehrerer plattenförmigen Mikrokomponenten 1. Zur besseren Verdeutlichung wird in den Fig. jeweils nur eine einzige aufgenommene Mikrokomponente 1 dargestellt. Eine beispielsweise aus Kunststoff bestehende Trägerschiene 2 ist auf einer Trägerplatte 3 befestigt. Die Trägerschiene 2 weist einen längsverlaufenden Einsteckschlitz 4 auf, in den die plattenförmige Mikrokomponente 1 mit einer Sockelleiste 5 einsteckbar ist. Die Sockelleiste 5 ist von seitlichen Ausnehmungen 6 begrenzt, die an den Enden des Einsteckschlitzes 4 zur Anlage kommen und damit eine exakte Festlegung der Einstecktiefe gewährleisten.

An dem einen Ende 4a des Einsteckschlitzes 4 ist eine in Schlitzlängsrichtung wirkende Feder 7, beispielsweise eine Blattfeder, angeordnet, die den Sockel 5 der plattenförmigen Mikrokomponente 1 gegen einen Zentrieranschlag 8 am anderen Ende 4b des Einsteckschlitzes 4 drückt.

In der einen Seitenwand 9 des Einsteckschlitzes 4 sind mehrere Gewindebohrungen 10 vorgesehen, die sich quer zur Ebene der plattenförmigen Mikrokomponente 1 erstrecken und zur Aufnahme jeweils einer Anschlussverschraubung 10a vorgesehen sind, durch die flüssige oder gasförmige Stoffe der Mikrokomponente 1 zugeführt oder von dieser abgeführt werden. Nach dem Einstecken der Mikrokomponente 1 in den Einsteckschlitz 4 werden die Anschlussverschraubungen gegen die Mikrokomponente 1 verschraubt und dadurch dicht an Anschlüsse 11 in der Außenseite 1a der plattenförmigen Mikrokomponente gedrückt.

In der der Seitenwand 9 gegenüberliegenden Seitenwand 12 des Einsteckschlitzes 4 sind elektrische Kontaktflächen 13, beispielsweise Kontaktfedern, angeordnet, die nach dem Einstecken der Mikrokomponente 1 mit zugeordneten elektrischen Kontakten 14 auf der zugekehrten Außenfläche 1b in Berührung kommen und zum elektrischen Anschluss dienen.

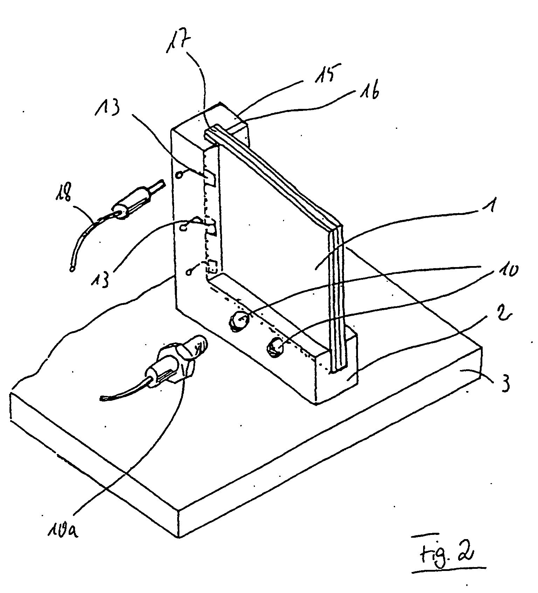

Das Ausführungsbeispiel nach Fig. 2 unterscheidet sich nach dem Ausführungsbeispiel nach Fig. 1 im Wesentlichen dadurch, dass die Trägerschiene 2 mit einer Anschlussschiene 15 verbunden ist, die sich senkrecht zur Trägerplatte 3 erstreckt und ebenfalls einen Einsteckschlitz 16 zur Aufnahme eines weiteren Einsteckrandes 17 der plattenförmigen Mikrokomponente 1 aufweist.

Bei dem Ausführungsbeispiel nach Fig. 2 sind in der mit der Trägerplatte 3 verbundenen Trägerschiene 2 nur die Gewindebohrungen 10 zur Aufnahme der Anschlussverschraubungen 10a vorgesehen. Die beschriebenen elektrischen Kontaktflächen 13 sind nur in der Anschlussschiene 15 angeordnet und dienen zum Anschluss elektrischer Leitungen 18.

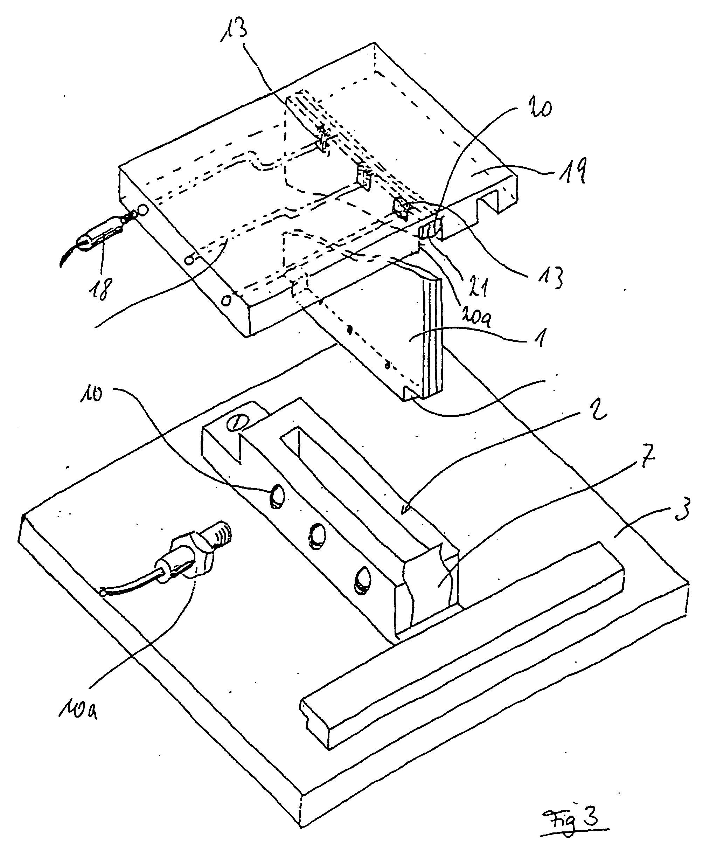

Das Ausführungsbeispiel nach Fig. 3 unterscheidet sich von den vorher beschriebenen Ausführungsbeispielen im wesentlichen dadurch, dass ein von der Trägerschiene 2, die auch hier nur die Gewindebohrungen 10 aufweist, getrennter Anschlusshalter 19 mehrere Aufnahmeschlitze 20 für einen Rand 21 der plattenförmigen Mikrokomponente 1 aufweist. In der einen Seitenwand 20a des Aufnahmeschlitzes 20 sind die elektrischen Kontaktflächen 13 angeordnet, die mit den zugeordneten Kontakten 14 der plattenförmigen Mikrokomponente 1 in Berührung stehen. Der Anschlusshalter 19, der auch in geeigneter Weise mit der Trägerplatte 3 verbunden bzw. an dieser befestigt sein kann, fixiert die aufgenommene Mikrokomponente 1 bzw. mehrere solcher aufgenommenen Mikrokomponenten 1 zusätzlich. Obwohl in Fig. 3 lediglich zwei Aufnahmeschlitze 20 für zwei hintereinander angeordnete Mikrokomponenten 1 dargestellt sind, können sowohl die Trägerschienen 2 als auch der Anschlusshalter 19 so ausgestaltet werden, dass auch bei den in den Fig. 1 und 2 gezeigten Ausführungsbeispielen mehrere, gegebenenfalls eine große Anzahl von Mikrokomponenten 1 hintereinander angeordnet werden können und ein einheitliches Anschlusssystem bilden.

Bei allen gezeigten Ausführungsbeispielen können durch Anordnung mehrerer Trägerschienen 2 auf einer gemeinsamen Trägerplatte 3 mehrere Mikrokomponenten 1 aufgenommen werden. So lassen sich durch Hintereinanderschalten mehrerer Mikrokomponenten 1 mehrstufige oder auch parallele Reaktionen auf kleinstem Raum durchführen. Auch können mehrere Trägerschienen 2 direkt miteinander verbunden werden und gegebenenfalls auf diese Weise die gemeinsame Trägerplatte 3 bilden.

## Patentansprüche

1. Anschlusssystem für plattenförmige Mikrokomponenten zur Durchführung von chemischen Reaktionen mit mehreren gemeinsam befestigbaren Trägerschienen (2), die auf einer Trägerplatte (3) befestigbar sind, wobei die Trägerschienen (2) einen Einsteckschlitz (4) zur Aufnahme eines Einsteckrandes (5) einer plattenförmigen Mikrokomponente (1) aufweisen und wobei in mindestens einer der beiden Seitenwände (9, 12) des Einsteckschlitzes (4) jeder Trägerschiene (2) Leitungsanschlüsse (10, 10a, 13) zur Leitung flüssiger und gasförmiger Stoffkomponenten vorgesehen sind, die mit zugeordneten Anschlüssen (11, 14) in mindestens einer Außenseite (1a, 1b) der plattenförmigen Mikrokomponente (1) verbindbar sind.

2. Anschlusssystem nach Anspruch 1, **dadurch gekennzeichnet, dass** mehrere Trägerschienen (2) miteinander zu einer Trägerplatte (3) verbunden sind.

3. Anschlusssystem nach Anspruch 1, **dadurch gekennzeichnet, dass** mehrere Trägerschienen (2) auf einer Trägerplatte (3) befestigt sind.

4. Anschlusssystem nach einem der voranstehenden Ansprüche, **dadurch gekennzeichnet, dass** mindestens eine der Seitenwände (9) des Einsteckschlitzes (4) mindestens eine Gewindebohrung (10) zur Aufnahme einer Anschlussverschraubung (10a) aufweist, die gegen die zugeordnete Außenseite (1a) der plattenförmigen Mikrokomponente (1) schraubbar ist.

5. Anschlusssystem nach einem der voranstehenden Ansprüche, **dadurch gekennzeichnet, dass** an einem Ende (4a) des Einsteckschlitzes (4) eine in Schlitzlängsrichtung wirkende Feder (7) angeordnet ist, durch die die plattenförmige Mikrokomponente (1) gegen einen Zentrieranschlag (8) am anderen Ende (4b) des Einsteckschlitzes (4) drückbar ist.

6. Anschlusssystem nach einem der voranstehenden Ansprüche, **dadurch gekennzeichnet, dass** zwischen den Gewindebohrungen (10) oder in der gegenüberliegenden Seitenwand (12) des Einsteckschlitzes (4) elektrische Kontaktflächen (13) angeordnet sind, die mit zugeordneten elektrischen Kontakten (14) der plattenförmigen Mikrokomponente (1) in Berührung bringbar sind.

7. Anschlusssystem nach einem der Ansprüche 2 bis 6, **dadurch gekennzeichnet, dass** die Trägerschienen (2) mit einer sich senkrecht zur Trägerplatte (3) erstreckenden Anschlussschiene (15) verbunden sind, die Einsteckschlitze (16) zur Aufnahme eines weiteren Einsteckrandes (17) jeder plattenförmigen Mikrokomponente (1) aufweist, wobei in mindestens einer der beiden Seitenwände jedes Einsteckschlitzes (16) der Anschlussschiene (15) Leitungsanschlüsse (13) vorgesehen sind, die mit zugeordneten Anschlüssen in mindestens einer Außenseite jeder plattenförmigen Mikrokomponente (1) verbindbar sind.

8. Anschlusssystem nach Anspruch 7, **dadurch gekennzeichnet, dass** die Trägerschienen (2) die Gewindebohrungen (10) zur Aufnahme der Anschlussverschraubungen (10a) und die Anschlussschiene (15) elektrische Kontaktflächen (13) aufweist.

9. Anschlusssystem nach einem der voranstehenden Ansprüche, **dadurch gekennzeichnet, dass** ein von den Trägerschienen (2) getrennter Anschlusshalter (19) Aufnahmeschlitze (20) für einen Rand (21) der plattenförmigen Mikrokomponenten (1) aufweist und dass in mindestens einer Seitenwand (20a) der Aufnahmeschlitze (20) elektrische Kontaktflächen (13) angeordnet sind, die mit zugeordneten Kontakten der plattenförmigen Mikrokomponente in Berührung bringbar sind.

## Claims

1. Interconnection system for plate-like microcomponents, having a plurality of jointly attachable support rails (2) which can be attached to a support plate (3), where the support rails (2) have an insertion slot (4) for the accommodation of an insertion edge (5) of a plate-like microcomponent (1) and where line connections (10, 10a, 13) which can be connected to associated connections (11, 14) for liquid and gaseous substance components in at least one outside (1a, 1b) of the plate-like microcomponent (1) are provided in at least one of the two side walls (9, 12) of the insertion slot (4) of each support rail (2).

2. Interconnection system according to Claim 1, **characterised in that** a plurality of support rails (2) are connected to one another to form a support plate (3).

3. Interconnection system according to Claim 1, **characterised in that** a plurality of support rails (2) are attached to a support plate (3).

4. Interconnection system according to one of the preceding claims, **characterised in that** at least one of the side walls (9) of the insertion slot (4) has at least one threaded hole (10) for the accommodation of a screw connection (10a) which can be screwed against the associated outside (1a) of the plate-like microcomponent (1).

5. Interconnection system according to one of the preceding claims, **characterised in that** arranged at one end (4a) of the insertion slot (4) is a spring (7) which acts in the longitudinal direction of the slot and by means of which the plate-like microcomponent (1) can be pressed against a centring stop (8) at the other end (4b) of the insertion slot (4).

6. Interconnection system according to one of the preceding claims, **characterised in that** electrical contact surfaces (13) which can be brought into contact with associated electrical contacts (14) of the plate-like microcomponent (1) are arranged between the threaded holes (10) or in the opposite side wall (12) of the insertion slot (4).

7. Interconnection system according to one of Claims 2 to 6, **characterised in that** the support rails (2) are connected to a connection rail (15) which extends perpendicular to the support plate (3) and has insertion slots (16) for the accommodation of a further insertion edge (17) of each plate-like microcomponent (1), with line connections (13) which can be connected to associated connections in at least one outside of each plate-like microcomponent (1) being provided in at least one of the two side walls of each insertion slot (16) of the connection rail (15).

8. Interconnection system according to Claim 7, **characterised in that** the support rails (2) have the threaded holes (10) for the accommodation of the screw connections (10a), and the connection rail (15) has electrical contact surfaces (13).

9. Interconnection system according to one of the preceding claims, **characterised in that** a connection holder (19) which is separate from the support rails (2) has accommodation slots (20) for an edge (21) of the plate-like microcomponents (1), and **in that** electrical contact surfaces (13) which can be brought into contact with associated contacts of the plate-like microcomponent are arranged in at least one side wall (20a) of the accommodation slots (20).

## Revendications

1. Système de connexion pour microcomposants sous forme de plaques, prévu pour l'exécution de réactions chimiques, avec plusieurs barrettes supports (2) pouvant être fixées entre elles et être attachées sur une plaque support (3), les dites barrettes supports (2) comportant une fente d'insertion (4) destinée au logement d'une arête d'insertion (5) d'un microcomposant sous forme de plaque (1), des raccords de conducteurs (10, 10a, 13) étant prévus dans une des deux parois latérales (9, 12) au moins de la fente d'insertion (4) de chaque barrette support (2), lesdits raccords pouvant être reliés à des raccords correspondants (11, 14) destinés au transport de composants en matières liquides et gazeuses dans un côté extérieur (1a, 1b) au moins du microcomposant sous forme de plaque (1).

2. Système de connexion selon la revendication 1, **caractérisé en ce que** plusieurs barrettes supports (2) sont reliées entre elles pour former une plaque support (3).

3. Système de connexion selon la revendication 1, **caractérisé en ce que** plusieurs barrettes supports (2) sont fixées sur une plaque support (3).

4. Système de connexion selon l'une quelconque des revendications ci-avant, **caractérisé en ce qu'**une des parois latérales (9) au moins de la fente d'insertion (4) comprend un taraudage (10) au moins destiné au logement d'un raccord vissé (10a) pouvant être vissé contre le côté extérieur (1a) correspondant du microcomposant sous forme de plaque (1).

5. Système de connexion selon l'une quelconque des revendications ci-avant, **caractérisé en ce qu'**un ressort (7) est disposé à une extrémité (4a) de la fente d'insertion (4), ledit ressort (7) agissant dans le sens longitudinal de la fente et au moyen duquel le microcomposant sous forme de plaque (1) peut être poussé contre une butée de centrage (8) prévue de l'autre côté (4b) de ladite fente d'insertion (4).

6. Système de connexion selon l'une quelconque des revendications ci-avant, **caractérisé en ce que** des surfaces de contact électrique (13) sont disposées entre les taraudages (10) ou dans la paroi latérale (12) opposée de la fente d'insertion (4), lesdites surfaces de contact pouvant entrer en contact avec des contacts électriques (14) correspondants du microcomposant sous forme de plaque (1).

7. Système de connexion selon l'une quelconque des revendications 2 à 6, **caractérisé en ce que** les barrettes supports (2) sont reliées à une barrette d'assemblage (15) s'étendant verticalement par rapport à la plaque support (3), ladite barrette comprenant des fentes d'insertion (16) destinées au logement d'une arête d'insertion (17) complémentaire de chaque microcomposant sous forme de plaque (1), des raccords de conducteurs (13) étant prévus dans une des deux parois latérales au moins de chaque fente d'insertion (16) de la barrette d'assemblage (15), les dits raccords pouvant être reliés à des raccords correspondants dans un côté extérieur au moins de chaque microcomposant sous forme de plaque (1).

8. Système de connexion selon la revendication 7, **caractérisé en ce que** les barrettes supports (2), les taraudages (10) destinés au logement des raccords vissés (10a) et la barrette d'assemblage (15) comportent des surfaces de contact électrique (13).

9. Système de connexion selon l'une quelconque des revendications ci-avant, **caractérisé en ce qu'**un support d'assemblage (19) indépendant des barrettes supports (2) comprend des fentes d'insertion (20) pour une arête (21) des microcomposants sous forme de plaque (1), et que dans une paroi latérale (20a) au moins des fentes d'insertion (20) sont disposées des surfaces de contact électrique (13) pouvant entrer en contact avec des contacts correspondants du microcomposant sous forme de plaque.
